# EUROPEAN PATENT APPLICATION

(11) **EP 1 104 056 A1**
(43) Date of publication of application: **30.05.2001**
(21) Application number: 99122970.9
(22) Date of filing: 18.11.1999
(51) Int. Cl.: H01S 5/183, H01L 33/00

(54) **A polarization controlled vertical-cavity surface-emitting laser**

(71) Applicant: Avalon Photonics Ltd, 8048 Zürich (CH)
(72) Inventor: Brunner, Marcel, 8049 Zürich (CH)
(74) Representative: Grünecker, Kinkeldey, Stockmair & Schwanhäusser Anwaltssozietät

(57) **Abstract**

The present invention provides a VCSEL device and a method of fabricating the same. The VCSEL device comprises a compound of first and second mirror means (103,105) and a laser-active region (101) disposed between said first and second mirror means, wherein said first and second mirror means and said laser-active region are formed on a surface of a substrate (107). Said VCSEL device further comprises a strain element (114) for applying mechanical strain to said compound, wherein said strain element is adapted to anisotropically strain said compound, thereby causing preferential emission of light of a single polarization.

## Description

The present invention relates to a vertical-cavity surface emitting laser (VCSEL) comprising a compound of first and second mirror means and a laser active region disposed between said first and second mirror means, wherein said first and second mirror means and said laser active region are formed on a surface of a substrate.

The present invention further relates to a method of fabricating the above-described VCSEL device.

In recent years, vertical-cavity surface-emitting lasers (VCSEL) have steadily been gaining in importance due to their promising application in areas such as optical communications, optical interconnections, optical neuro-networks, and optical signal processing. The advantageous characteristics of a VCSEL device, such as low-threshold current, single mode operation, and the ability to be fabricated in high density arrays, suggest using these devices in integrated optoelectronic circuits. In a large variety of these applications, however, polarization-sensitive components are widely used. Accordingly, in these applications, a light source is needed that offers an effective control of the polarization state of the output light. In particular, varying polarization states of a laser device used for optical interconnections for data communication systems would intolerably increase bit errors and additionally cause noise in the signals.

Generally, VCSEL devices provide a circular beam profile due to the cylindrical symmetry of the device, which is an advantageous characteristic for a variety of applications. On the other hand, the cylindrical symmetry leads to two essentially degenerated orthogonal linearly polarized radiation modes. Thus, a strong polarization mode competition occurs and finally results in polarization flips and modal noise. This disadvantage of a VCSEL not only limits the utilization in view of data communication systems as mentioned above, but also prevents the VCSEL devices from being efficiently employed in gas detection and pumping of atomic clocks, since the slight wavelength difference of the polarization modes and the peak in the derivative of the light versus intensity curve at the polarization flip unduly complicate the measurements. In view of this situation, a large amount of research has been performed in order to solve the aforementioned problem.

As a consequence, a number of approaches have been suggested in the related art. In "IEEE Journal of Quantum Electronics", 34, page 1099, 1998, by T. Yoshikawa et al, a VCSEL is disclosed having a mesa with a non-cylindrical symmetry which results in a radiation mode having only one polarization direction. In this reference, the VCSEL devices were formed on a (001) surface of a GaAs substrate and the mesa of these devices was formed as rectangles, wherein the short side of the rectangle is parallel to the [110] direction. The length of the larger side of a rectangle was restricted to 6 µm to stabilize the fundamental transversal radiation mode.

In "Electronics Letters", 34, page 1401, 1998", by K.A. Ha et al., a VCSEL cavity having a non-cylindrical symmetry is attained by forming a longitudinal oxide aperture which leads to a preferred emission of a single polarization mode.

The VCSEL devices described in the above-mentioned references, however, work well only for small-device dimensions and, accordingly, the output power of these devices is limited. If such devices were to be scaled up to appropriate device sizes, stabilization of the second order transverse mode is favored. Moreover, the circular emission profile is distorted.

A further approach is described in "IEEE Photonics Technology Letters, 10, page 1676, 1998" by N. Ishiyama et al. According to this disclosure, an intrinsic anisotropic optical gain in the quantum wells can be obtained when the quantum well layers are grown on a non-(100) substrate. Furthermore, the operation of a VCSEL device substantially emitting in a single polarization mode is demonstrated, wherein the VCSEL device is grown on a GaAs (311) substrate. Semiconductor substrates having this orientation and further providing a crystal structure of high quality, however, are hardly available. Moreover, the epitaxial growth is difficult and, hence, the overall performance of these devices is significantly reduced compared to devices grown on (100) substrates.

"IEEE Photonic Technology Letters, 9, page 143, 1997", by Y.H. Chen et al., describes a VCSEL device in which advantage is taken of the fact that spontaneous ordering along the (-111) and (1-11) planes may occur when a GalnP layer is grown on a (001) substrate. This ordered configuration leads to a gain enhancement along the [110] direction and, accordingly, results in a stabilization of a single polarization mode. Since there are no materials emitting in the 760-980 nm region and undergoing a spontaneous ordering process when grown on an appropriate substrate, the employment of such VCSEL devices is strongly limited.

A further approach in providing a VCSEL device exhibiting a stable polarization mode is described in, for example, "Applied Physical Letters, 69, page 7, 1996", by S.J. Chablitzy et al., and in "IEEE Journal of Selected Topics in Quantum Electronics, 1, page 667, 1995", by T. Mokihara, et al. In these papers, polarization control by using polarizing sub-wavelength gratings is suggested. These gratings may be etched into the semiconductor, in dielectric coatings, or in a metal on top of the VCSEL. Due to the polarizing gratings, the reflectivities of the distributed Bragg reflectors depend on the polarization, and therefore a preferred polarization mode can be stabilized in conformity with the design of the grating. Good process control during the formation of sub-wavelength gratings, however, is difficult and cost-intensive.

A further method for stabilizing a single polarization mode is described in "Applied Physical Letters 69, page 1041, 1969", by A.K. Janssen van Dorn et al. This paper reports of a VCSEL structure in which temperature-induced strain is created so as to influence the polarization direction. An external laser beam was focused on the surface next to a lasing VCSEL element to thereby produce a lateral temperature gradient and a strain field in the VCSEL element. This method, however, seems only applicable in a laboratory, or would at least require complex and complicated additional equipment for producing said laser beam.

In view of the above-mentioned problems, a need exists for a VCSEL device which is capable of emitting in a single polarization mode, wherein the drawbacks of the prior art devices are avoided.

### SUMMARY OF THE INVENTION

According to a first aspect of the present invention, there is provided a vertical-cavity surface-emitting laser comprising a compound of first and second mirror means and a laser-active region disposed between said first and second mirror means, wherein said first and second mirror means and said laser active region are formed on a surface of a substrate, the vertical-cavity surface-emitting laser being characterized by comprising a strain element for applying mechanical strain to said compound, said strain element being adapted to anisotropically strain said compound for causing preferential emission of light of a single polarization.

Although a physical thesis describing the fact that polarization tends to lock to the crystallographic axes (i.e., [110] and [1-10] axes, in case a crystalline (100) substrate) is not yet available, it is believed that an anisotropy of the elasto-optic tensor provides for the preference of these crystallographic axes in that a birefringence is created. The strain element of the inventive VCSEL device generates anisotropic mechanical strain in a region within the first and second mirror means and/or the active region and thus adds intentional birefringence to the laser cavity, thereby allowing the effective selection of a single polarization mode without affecting the beam shape characteristic of the device. In particular, a preferable circular beam shape may be obtained.

Preferably, said strain element comprises at least one deformation layer formed in said first or second mirror means and having a vertically shrunk peripheral portion, wherein said vertically shrunk peripheral portion has, with respect to a horizontal plane of the VCSEL device, a geometrical shape which has a different symmetry with respect to two linearly independent directions in said horizontal plane.

It is to be noted that the directional indications "vertical" and "horizontal" used in this application are considered as relative terms and refer to the direction of emission of the VCSEL device. Consequently, e.g. a horizontal plane is a plane parallel to the emitting surface of the VCSEL device.

According to the peripheral portion, which has been vertically shrunk, the first or second mirror means of the VCSEL device are deformed due to the vertical contraction of said peripheral portion. Since the horizontal symmetry of the peripheral portion does not coincide with that of the VCSEL, the deformation varies correspondingly and an anisotropic strain is applied to the VCSEL structure. Consequently, a preferred polarization direction may easily be selected by properly adjusting the geometric shape of said peripheral portion.

Preferably, said vertically shrunk peripheral portion comprises two opposing elongated segments.

By these opposing elongated segments within the peripheral portion a preferred horizontal line of deformation of the VCSEL structure is defined, thereby creating anisotropic strain in the VCSEL.

Advantageously, said strain element comprises a plurality of said deformation layers formed over each other so as to obtain an overall vertical shrinkage at the peripheral portions as a sum of the amounts of shrinkage of each of said deformation layer.

By providing a plurality of said deformation layers having coinciding vertically shrunk peripheral portions a required degree of deformation may be selected.

Preferably, said first and/or second mirror means comprise distributed Bragg reflectors formed of a stack of layers, said layers alternatively comprising a high concentration of a first material and a low concentration of said first material, wherein said deformation layers are formed by selectively oxidizing said first material.

Selective oxidation causes said first material containing layers to shrink in their thickness. Accordingly, the deformation layers can be performed by selective oxidation after the mesa is etched, and hence no additional process steps compared to a conventional oxidized VCSEL device are needed. The geometric shape of the vertically shrunk peripheral portions can easily be adjusted by selecting an appropriate mesa shape.

Advantageously, said opposing elongated segments are aligned substantially along a crystallographic axis of said surface of the substrate.

By this measure the elasto-optic characteristic of the VCSEL device along said crystallographic axis may suitably be adapted to select the corresponding polarization mode.

In a preferred embodiment, said first material is aluminum.

Since aluminum-containing layers are widely used in VCSEL devices, the characteristics of depositing and treating such layers is well known in the art and corresponding procedural steps are able to be well-controlled.

Advantageously, the vertical shrinkage of said deformation layer is larger than 5%.

Thus, it is ensured that, either by providing a single deformation layer having an initial thickness of about 1 µm or by shrinking a part of the alternating layers of the Bragg reflector, a sufficient degree of deformation is obtained.

Preferably, a lateral dimension of said elongated segment is substantially half of an oxidation depth of said first material.

This provides for a substantially fully oxidized elongated segment when shrinkage of said peripheral portion is carried out by selectively oxidizing said deformation layer. According to a second aspect of the present invention, there is provided a method of fabricating a VCSEL, comprising the steps of: providing a crystalline substrate, forming a compound of first mirror means and second mirror means, and a laser-active region on a surface of said crystalline substrate, wherein said laser-active region is disposed between said first and second mirror means, said method being characterized by comprising the step of forming a strain element in said compound, for applying mechanical strain to said compound, wherein said strain element is adapted to anisotropically strain said compound for causing preferential emission of light of a single polarization.

The advantages provided by a VCSEL device manufactured by the method as described above are the same as those pointed out with reference to the first aspect of the present invention.

In a preferred embodiment, the step of forming said strain element comprises selectively oxidizing a first material in a stack of layers having alternatingly a high concentration and a low concentration of said first material.

Since selective wet-oxidation is a well-known procedure in the art, the formation of the strain element conveniently fits into a standard manufacturing process, thereby avoiding any additional complicated fabrication steps.

Advantageously, the selective oxidation is performed after etching a mesa containing said stack of layers, wherein an oxidation mask is used which matches a shape of said peripheral portion.

According to this feature, the strain element can be formed by employing all the procedural steps necessary for a conventional oxidized device, wherein only the shape of the oxidation mask (or 'mesa etch mask') has to be adapted accordingly.

In a further preferred embodiment, shrinkage of said deformation layer is obtained by forming a vertical opening, said opening being in contact with said peripheral portion, and by oxidizing said deformation layer using said opening.

By this measure, the vertical opening, which may be formed by an appropriate etch process, can be employed to select the portion, where the thickness of the peripheral portion has to be decreased in order to create the required mechanical strain.

Further advantages and features of the present invention follow from the dependent claims and the detailed description which is given with reference to the drawings, wherein:
FIG. 1 is a schematic cross-sectional view of a typical example of a prior art VCSEL device;
FIGs 2a and 2c are schematic cross-sectional views along the lines llb - llb and llc - llc, respectively, of the embodiment shown in FIG. 2a;
FIGS. 2b is a schematic top view of a VCSEL device according to a preferred embodiment of the present invention;
FIGS. 3a-3d are schematic top views of a plurality of variations of the embodiment shown in FIGS. 2a, 2b and 2c.

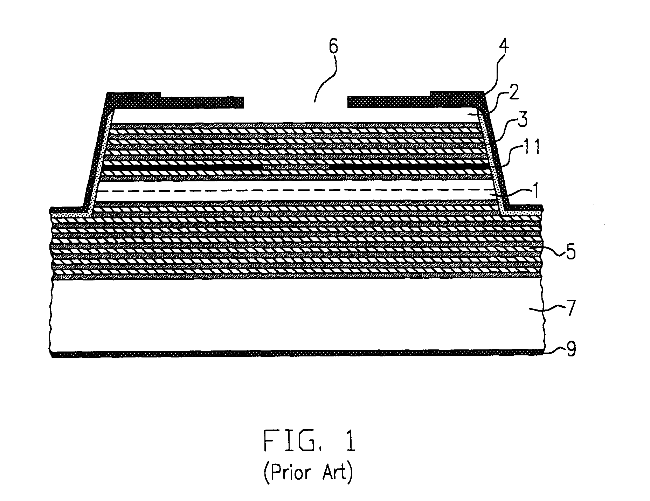

With reference to FIG. 1, a typical prior art VCSEL device is briefly discussed in order to facilitate understanding of the present invention.

In FIG. 1, the bottom surface of a substrate layer 7, having substantially a [001] crystallographic axis as a direction perpendicular to the surface, is covered by a metal layer 9. Over the substrate layer 7, a laser-active region 1 is formed. Active region 1 is disposed between second mirror means 5 formed over substrate layer 7, and first mirror means 3. First and second mirror means 3, 5 are formed as distributed Bragg reflectors and are composed of distinct layers having, alternatingly, a high index and a low index of refraction. Mirror means 3 and 5 define an optical resonator for a predetermined wavelength. On top of mirror means 3, a transparent cap layer 2 is formed, which in turn is partly covered by a metal top layer 4. An opening 6 of the top metal layer 4 serves as a radiation emission window. Optical confinement of the radiation created within active region 1 is obtained by firstly a mesa containing the first mirror means 3 and, secondly, by a resistance layer 11 which may be formed by, for example, selective oxidation of resistance layer 11 which comprises a high aluminum content during the formation of the mesa, thereby providing an electrically insulating peripheral portion in resistance layer 11. During oxidation of resistance layer 11 the Al of the layer is converted into Al₂O₃ up to a oxidation depth of about 10µm. The peripheral portion of high electrical resistance of resistance layer 11 is illustrated in black color in FIG. 1. The portion of resistance layer 11 which is not oxidized substantially coincides with the lateral dimension of the opening 6 and serves additionally as an optical aperture.

In operation, an electric current is supplied to the active region 1 via top metal layer 4, which may be comprised of a stack of metal layers such as Pt, Ti and Au, and via metal layer 9. Due to the high electrical resistance of the peripheral portion of resistance layer 11, current density is concentrated in the central portion of this layer, and, accordingly, a high current density in active region 1 corresponding to the central portion of resistance layer 11 is achieved, since resistance layer 11 is formed vertically in the vicinity of active region 1. Preferably, the horizontal dimension of the central portion of resistance layer 11 as well as the horizontal dimensions of opening 6 are selected so as to stabilize the fundamental transverse radiation mode. According to the desired cylindrical symmetry of the mesa containing first mirror means 3, the polarization of the emitted radiation is mainly polarized along either the [110] or the [1-10] crystal axis of the substrate. Due to changing conditions during the operation of the VCSEL device, such as increased temperature, the once aligned polarization direction may flip into the orthogonal direction and thus render this device inappropriate for polarization-sensitive applications.

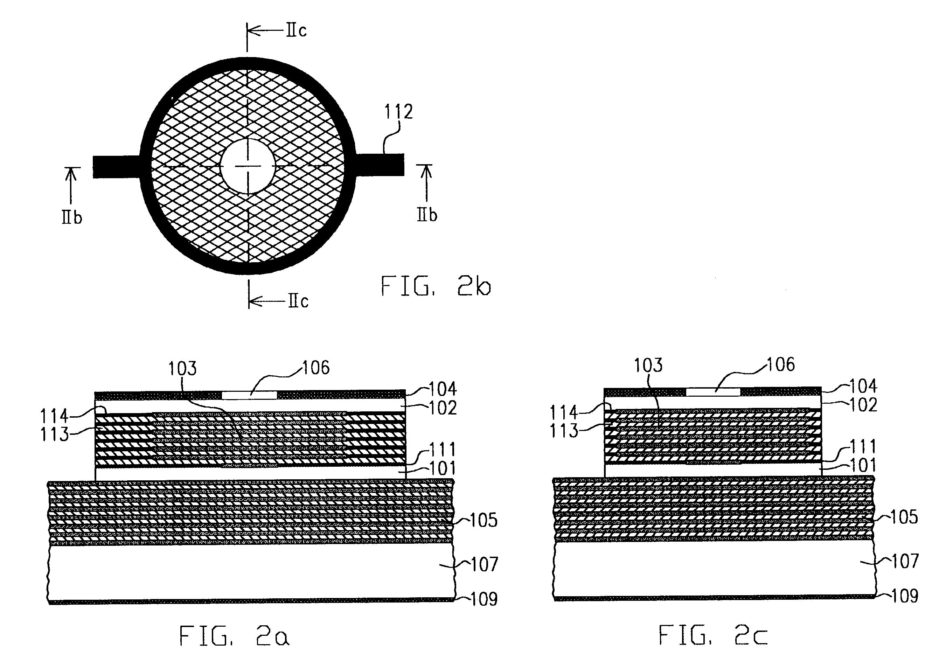

FIG. 2b shows a schematic top view of the preferred embodiment, and FIGs 2a and 2c are cross-sectional views along the along the lines IIb - IIb and IIc - IIc, respectively.

In FIG. 2a, an active region 101 is disposed between first mirror means 103 and second mirror means 105. First and second mirror means 103, 105 are formed as distributed Bragg reflectors composed as a stack of layers having, alternatingly, high and low indexes of refraction. Second mirror means 105 is formed over a crystalline substrate 107 having a [001] crystallographic axis substantially perpendicular to the surface of substrate 107. The bottom surface of substrate 107 is covered by a metal layer 109. On top of first mirror means 103, a cap layer 102 is provided which, in turn, is partly covered by a top metal layer 104 having an opening 106 in its central portion so as to form a radiation emission window. Over the active region 101, a resistance layer 111 is provided having a peripheral portion with high electrical resistance and a transparent central portion with a low electrical resistance. In this embodiment, resistance layer 111 is deposited as a layer which mainly consists of Al As of about 25 nm thickness. During the further procedure, the peripheral portion of high electrical resistance is formed by selectively oxidizing the VCSEL structure, wherein the high aluminum content in resistance layer 111 is oxidized into Al₂O₃ to a depth of approximately 10 µm. The oxidation of the aluminum leads to a vertical shrinkage of the corresponding portion of about 6.7% Due to the vertical contraction of the peripheral portion of the resistance layer 111, a small amount of mechanical strain is applied to the mesa containing mirror means 103. This mechanical strain, however, exhibits horizontally no preferential direction due to the circular symmetry of resistance layer 111 and of the mesa.

The stack of layers of mirror means 103 are formed of AlₓGa₁₋ₓAs layers, having, alternatively, a high and a low concentration of aluminum. During oxidation, typically low Al content layers 113 are not oxidized at all, whereas high Al content layers 114 (Al content is about 90%) will be oxidized to a depth of approximately 2 µm. Due to the vertical contraction of the oxidized portions of the layers 114, an overall contraction at the periphery of the mesa is achieved depending on the numbers of layers of the distributed Bragg reflector 103. In this example, twenty layers of 50 nm thickness are used and yield a total contraction of up to 67 nm, thereby effecting a deformation of the mesa and applying a strong mechanical strain to the mesa structure. In FIG. 2, only a few alternating layers 113, 114 are shown for the sake of a convenient illustration. In order to obtain a preferential horizontal direction, the peripheral portion of the layers having a high Al content 114, which serve as deformation layers, are formed so as to comprise elongated opposing segments 112. Said Segments 112 are formed by means of an accordingly structured mesa etch mask. Hence, according to this embodiment the formation of the strain element does not require any additional process steps, merely the mesa etch mask has to be patterned suitably. A lateral dimension of said elongated segments is preferably selected so as to substantially coincide with half of the oxidation depth which in this case is approximately 2 µm. Consequently, the elongated segments are completely oxidized in all high-Al content layers, if the width of the segments is smaller than half of the oxidation depth in these layers.

FIG. 2b schematically shows a top view of the embodiment, in which the segments 112 are horizontally aligned. Preferably, segments 112 are aligned along the crystallographic axis representing the preferred polarization directions (in this example [110] or [1-10] direction) so that the inherent polarization direction of the VCSEL device is stabilized rather than forcing the polarization into any arbitrary direction.

FIG. 2c shows the VCSEL device in an arrangement in which the VCSEL device is rotated by 90° with respect to the vertical axis. As can be seen from FIG. 2c, the oxidized portions of high content layer 114 extend merely to a depth of about 2 µm.

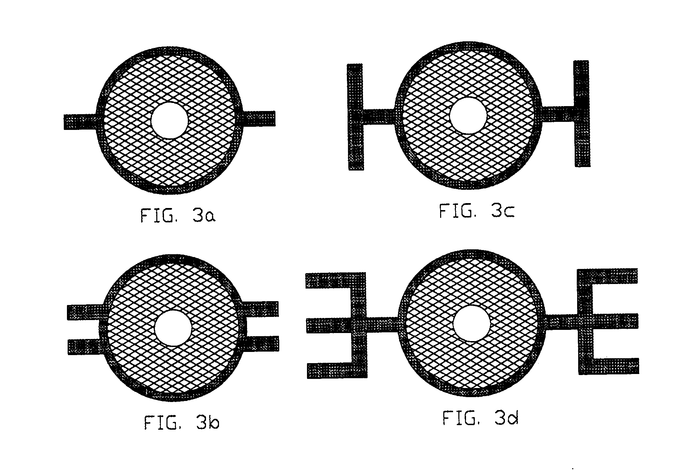

FIGS. 3a-3d show schematic top views of further possible mesa configurations so as to increase the mechanical strain applied to the mesa in order to more effectively suppress an undesired polarization mode.

Although the above embodiment is described with reference to specific materials and a specific number of layers used in the distributed Bragg reflector, it is to be understood that any appropriate material composition as well as any suitable configuration of the distributed Bragg reflector may be applied in conformity with the method and the VCSEL device according to the present invention. In particular, the geometrical form of the mesa is not limited to the forms as presented in FIGS. 3a-3d, but any suitable form may be used. Moreover, a single deformation layer may be provided, wherein the degree of deformation is adjusted by the initial thickness of the deformation layer prior to the shrinkage procedure such as selective oxidation.

Furthermore, although the above embodiment is described with reference to a cylindrically symmetric structure, other geometric forms such as squares, rectangles, etc. of the laser cavity may be used. In particular, further means for applying additional asymmetries may be employed, such as non-circular mesas or metal contacts applied to the top Bragg mirror, so as to suppress non-lasing polarization modes.

In a further preferred embodiment, the strain element comprises a heating layer having resistor areas in defined relationship to the crystallographic orientation of the substrate. Furthermore, additional contact electrodes and conducting lines connecting the resistor areas with the contact electrodes may be provided such that a current may be selectively applied to specific resistor areas, thereby locally heating the VCSEL device. Due to the heat deposited in the VCSEL device, a switchable asymmetric mechanical strain is created depending on the selected resistor areas. Advantageously, the direction of the preferred polarization mode may be selected by turning on respective resistor areas. The material composition of the resistor area, i.e. the specific resistance, is chosen such that a deposition of a sufficient amount of heat energy in a sufficient small area is attained.

In a further preferred embodiment, the strain element comprises a piezo-electric layer disposed between corresponding electrode layers which are patterned so as to define a preferential horizontal direction. Furthermore, the respective electrode layers are connected via conducting lines with external electrodes to allow selective operation of corresponding segments of the electrode layer. By applying a voltage to respective electrode segments of the electrode layers, mechanical strain is transferred to the VCSEL structure. Accordingly, the polarization mode of the emitted radiation may be controlled by applying a voltage to the respective electrode segments, thereby allowing a switchable polarization mode control.

## Claims

1. A vertical-cavity surface emitting laser (VCSEL) comprising a compound of first (103) and second (105) mirror means and a laser active region (101) disposed between said first and second mirror means, wherein said first (103) and second (105) mirror means and said laser active region (101) are formed on a surface of a substrate (107),
**characterized in that**
said VCSEL comprises a strain element (114) for applying mechanical strain to said compound, said strain element (114) being adapted to anisotropically strain said compound for causing preferential emission of light of a single polarization.

2. The VCSEL of claim 1, wherein said strain element comprises at least one deformation layer (114) formed in said first or second mirror means and having a vertically shrunk peripheral portion, wherein said vertically shrunk peripheral portion has, with respect to a horizontal plane of the VCSEL device, a geometrical shape which has a different symmetry with respect to two linearly independent directions in said horizontal plane.

3. The VCSEL of claim 2, wherein said vertically shrunk peripheral portion comprises two opposing elongated segments (112).

4. The VCSEL of claim 2 or 3, wherein said strain element comprises a plurality of said deformation layers formed over each other so as to obtain an overall vertical shrinkage at the peripheral portions as a sum of the amounts of shrinkage of each of said deformation layer.

5. The VCSEL of any of claims 2 to 4, wherein said first and/or second mirror means comprise distributed Bragg reflectors formed of a stack of layers, said layers alternatively comprising a high concentration of a first material and a low concentration of said first material, wherein said deformation layers of said strain element are formed by selectively oxidizing said first material.

6. The VCSEL of claim 3, wherein said opposing elongated segments are aligned substantially along a crystallographic axis of said surface of the substrate.

7. The VCSEL of claim 5, wherein said first material is aluminum.

8. The VCSEL of any of claims 2 to 7, wherein the vertical shrinkage of said deformation layer is larger than 5% of an initial thickness of the deformation layer.

9. The VCSEL of claim 4, wherein a lateral dimension of said elongated segment is substantially half of an oxidation depth of said first material.

10. The VCSEL of claim 1, wherein said strain element comprises a heating element for anisotropically heating portions of the VCSEL device to obtain anisotropic strain.

11. The VCSEL of claim 1, wherein said strain element comprises a piezo element for creating anisotropic strain.

12. The VCSEL of claims 11 or 12, wherein said strain element comprises a means for selctively switching said anisotropic strain.

13. A method of fabricating a VCSEL, comprising the steps of:
providing a crystalline substrate,
forming a compound of a first mirror means and a second mirror means, and a laser active region on a surface of said crystalline substrate, wherein said laser active region is disposed between said first and second mirror means,
**characterized in that**
said method comprises the step of forming a strain element in said compound, for applying mechanical strain to said compound, wherein said strain element is adapted to anisotropically strain said compound for causing preferential emission of light of a single polarization.

14. The method of claim 13, wherein formation of said strain element further comprises:
forming at least one deformation layer formed in said first or second mirror means and having a vertically shrunk peripheral portion, wherein said vertically shrunk peripheral portion has, with respect to a horizontal plane of the VCSEL device, a geometrical shape with a different symmetry with respect to two linearly independent directions in said horizontal plane.

15. The method of claim 14, comprising forming of two opposing elongated segments in said vertically shrunk peripheral portion.

16. The method of claim 14 or 15, wherein a plurality of said deformation layers is formed over each other so as to obtain an overall vertical shrinkage at the peripheral portions as a sum of the individual amounts of shrinkage of each of said deformation layer.

17. The method of any of claims 13 to 16, wherein said first and/or second mirror means are formed as distributed Bragg reflectors comprising of a stack of layers, said layers alternatively comprising a high concentration of a first material and a low concentration of said first material, wherein said deformation layers of said strain element are formed by selectively oxidizing said first material.

18. The method of claim 17, wherein the step of forming said strain element comprises selectively oxidizing said first material to obtain a sufficient amount of shrinkage of said peripheral portions.

19. The method of claim 18, wherein the selective oxidation is performed after etching a mesa containing said first mirror means, wherein a mesa etch mask is used which matches the shape of said peripheral portion.

20. The method of claim 18, wherein vertically shrinking is carried out by forming a vertical opening, said opening being in contact with said peripheral portion, and by wet-oxidizing said first material using said opening.

21. The method of claim 17, wherein said first material is Al.

22. The method of any of claims 13 to 21, wherein an asymmetric laser aperture is provided.

23. The method of any of claims 13 to 22, wherein metal contacts are applied to the first and/or second mirror means for suppressing a non-lasing polarization.
